# EUROPEAN PATENT SPECIFICATION

(11) **EP 4 242 676 B1**
(45) Date of publication and mention of the grant of the patent: **15.07.2026**
(21) Application number: 22161286.4
(22) Date of filing: 10.03.2022
(51) Int. Cl.: G01R 31/367, G01R 31/392

(54) **HYBRID PARAMETRIC - MACHINE LEARNING BATTERY AGING MODEL**
HYBRIDES PARAMETRISCHES MASCHINENLERNMODELL ZUR BATTERIEALTERUNG
MODÈLE DE VIEILLISSEMENT DE BATTERIE PAR APPRENTISSAGE AUTOMATIQUE PARAMÉTRIQUE HYBRIDE

(43) Date of publication of application: 13.09.2023
(73) Proprietor: TWAICE Technologies GmbH, 80807 München (DE)
(72) Inventor: AYGÜL, Deniz Navdar, 80802 München (DE); KARGER, Alexander, 81667 München (DE); SINGER, Jan, 81371 München (DE); RAMOS ZAYAS, Juan, 81675 München (DE)
(74) Representative: Kraus & Lederer PartGmbB

(56) References cited:
- US-A1- 2021 373 082
- SHE CHENGQI ET AL: "Battery Aging Assessment for Real-World Electric Buses Based on Incremental Capacity Analysis and Radial Basis Function Neural Network", IEEE TRANSACTIONS ON INDUSTRIAL INFORMATICS, IEEE SERVICE CENTER, NEW YORK, NY, US, vol. 16, no. 5, 6 November 2019 (2019-11-06), pages 3345 - 3354, XP011773615, ISSN: 1551-3203, [retrieved on 20200213], DOI: 10.1109/TII.2019.2951843
- LEO WILDFEUER ET AL: "Concept for a hybrid semi-empirical and data-based model for state-of-health monitoring and aging prediction of li-ion battery packs", 1 January 2019 (2019-01-01), XP055716852, Retrieved from the Internet <URL:https://www.researchgate.net/profile/Leo_Wildfeuer/publication/330765254_Concept_for_a_hybrid_semi-empirical_and_data-based_model_for_state-of-health_monitoring_and_aging_prediction_of_li-ion_battery_packs/links/5c536599299bf12be3f10581/Concept-for-a-hybrid-semi-empirical-and-data-based-model-for-st> DOI: 10.13140/rg.2.2.29057.51043

## Description

### State of the art

Batteries, in particular lithium-ion based batteries but not only, are finding more use in private and industrial applications.

A correct use of the battery, in terms of charging and discharging profiles and cycles, has a significant impact on the battery performance and aging. This, in turn, requires knowledge of one or more states of the battery, for instance the state of charge, or the state of health.

Those states are generally not easily measurable, and are thus generally obtained by measuring data from the battery, such as voltage and/or current, and inputting those data into a model of the battery, from which one or more state can then be outputted.

The invention relates to how at least parts of those models can be efficiently configured. In particular, the models can be capable of modelling several aspects of the battery, one of which is the aging. It will be understood that such battery aging models can be a sub-part of more comprehensive models of a battery.

Parameterizing battery aging models can be implemented by collecting real-world operation data and creating a model based on the data. This approach, however, requires extensive testing of real-world operational batteries. That is, testing of batteries in the respective fields of use. This is mostly prohibitive, as the testing requires complex and time-consuming measurements, which are not compatible with real-world operation. Even if technically possible, this would result in unacceptable costs.

As an alternative, parameterizing battery aging models without real-world operation data can be done by testing a large amount of batteries in a laboratory.

This requires a long time, as a wide range of operating conditions must be reproduced in order to ensure an adequate model validity range. There are methods for reducing the amount of required testing for laboratory based aging models. This can be achieved by, for instance, optimizing the test points by design of experiments. However, a large amount of testing effort will always remain.

Additionally, it has been found that battery aging models that are parameterized on laboratory data are only valid for the tested conditions and for the specific cell. Extrapolation of battery aging models that are parameterized on laboratory data is possible in the linear regime of capacity fade, if the testing range in the laboratory is large enough. However, this increases the amount of testing needed and does not consider the non-linear regime of capacity fade. Although battery aging models have been proposed, which consider the non-linear regime of capacity fade, the test matrix required for such models becomes even larger.

Moreover, there is often a discrepancy between such battery aging models that are parameterized on laboratory measurements and the actual aging measured in real-world operation data. This is because, for instance, of system scaling effects such as, for instance, parallel and series connection of individual battery cells. Still further, parameterizing battery aging models based on operation data is not possible before battery operation, and requires a certain amount of battery aging. Additionally, as of present, there is no method for combining battery aging models based on laboratory data and battery aging models based on real-world operation data. Moreover, batteries are generally tested with constant conditions in the laboratory, which are not entirely representative of the dynamic conditions during real-world operation.

In the known prior art, it has been suggested to parameterize a battery aging model based on laboratory data and a battery aging model based on real-world operation data. This allows replacing the battery aging model based on the laboratory data by the battery aging model based on the real-world operation data, at a certain point in time. This is disclosed by, for instance, the article *"*Concept for a hybrid semi-empirical and data-based model for state-of-health monitoring and aging prediction of li-ion battery packs", by Leo Wildfeuer, Michael Baumann, and Markus Lienkamp, AABC Europe, Strasbourg, France, 2019. Nevertheless, this approach remains complex and the results are not always reliable.

US 2021/373082 A1 relates to a method for operating a motor vehicle depending on a predicted state of health of an electrical energy store, in particular a vehicle battery. A data-based state of health model may be configured as a hybrid model which applies a correction value, which results from a data-based correction model, in particular through addition or multiplication, to a modeled state of health, which is ascertained with the aid of a physical or physically-motivated aging model. The correction model (machine learning model) may thereby compensate for the inaccuracies of the physical aging model.

The publication by Chengqi She et al: "Battery Aging Assessment for Real-World Electric Buses Based on Incremental Capacity Analysis and Radial Basis Function Neural Network", IEEE TRANSACTIONS ON INDUSTRIAL INFORMATICS, IEEE SERVICE CENTER, NEW YORK, NY, US, vol. 16, no. 5, 6 November 2019 (2019-11-06), pages 3345-3354, XP011773615, discloses a neural network model (radial basis function neural network, RBFNN) for battery aging assessment which is based on massive battery data collected from real world electric city transit buses. Features including accumulated mileage of vehicles and initial charging SOC, average charging temperature, average charging current, and average operating temperature of battery systems are selected as the model inputs. Third peak values of incremental capacity (IC) curves are used as the model outputs to present battery aging levels as the parameter relates closely with the loss of lithium inventory (LLI) that is considered as primary cause of capacity degradation for LiFePO₄ batteries.

### Summary of the invention

Embodiments of the invention are generally based on a combined battery aging model, obtained by combining
- a battery aging parametric model, based on laboratory data, with
- a battery aging machine learning model, based on real-world operation data.

In some embodiments, such coupling comprises correcting the estimated aging state from the parametric model based on laboratory data with the output of the machine learning model, which has been preferably trained on actual measured aged batteries, that is, on real-world operation data.

Thanks to this approach, the amount of required testing can be reduced significantly, since the machine learning model can compensate missing operating ranges in the parametric model based on laboratory data.

Moreover, the combined battery aging model is no longer limited to the tested laboratory conditions, since the machine learning model can compensate missing operating ranges in the parametric model based on laboratory data.

Any discrepancy between laboratory data and real-world operation data can thus be compensated in the combined battery aging model.

The combined battery aging model can further run estimations before battery operation and does not require a certain amount of in-field battery aging, since the battery aging model based on laboratory data can be parameterized a priori.

The proposed combined battery aging model can further handle both constant and dynamic input data.

More specifically, the invention relates to a system for modelling at least one state of a battery, the system comprising a parametric battery model, configured to receive one or more inputs and to provide a first output based thereon, a machine learning model, which has been trained to correct an output of the parametric battery model based on battery operation comprising aging, configured to receive one or more inputs and the first output and to provide a second output based thereon, a combiner, configured to receive the first output and the second output and to provide a third output based thereon. In detail, the machine learning model has been trained based on at least the first output of the configured parametric battery model and a measured set of inputs of the battery, wherein the measured set of inputs of the battery is based on battery operation comprising aging.

In this manner it is advantageously possible to correct the output of the parametric model by means of the machine learning model. Since the machine learning model can be trained based on battery data incorporating aging effects it is possible to correct the parametric model so as to take into account those aging effects, and/or to model one or more aging mechanism in the machine learning model instead of, or in addition to, in the parametric model.

In some embodiments, the one or more inputs can comprise one or more among:
- temperature,
- depth of discharge,
- state of charge,
- voltage,
- current,
of the battery.

In this manner it is advantageously possible to provide inputs to the parametric model and to the machine learning model derived from simple measurement of the battery, which can also be taken on-site and during real world operation.

In some embodiments, the at least one state can be a state of health of the battery, the first output can be a first estimation of the state of health of the battery, the second output can be a correction of the first output, based on battery operation comprising aging, and the third output can be an improved estimation of the state of health of the battery, based on real-world battery operation.

In this manner it is advantageously possible to model the state of health of the battery in a reliable manner, while also allowing to model aging effects in a simple and reliable manner, thanks to the correction provided by the machine learning model.

In some embodiments, the parametric battery model can have been configured by a feedback loop based on a difference between the first output and a measured value of the at least one state of a battery.

In this manner it is advantageously possible to easily and reliably configure the parametric model.

In some embodiments, the machine learning model can be trained by using as ground truth a measured value of the at least one state of a battery OUT_{MEAS}.

In this manner it is advantageously possible to easily and reliably configure the machine learning model.

The invention also relates to a method for configuring a system for modelling at least one state of a battery, the system comprising a parametric battery model and a machine learning model, the method comprising the steps of configuring the parametric battery model based on at least a first measured set of inputs of the battery, training the machine learning model based on at least an output of the configured parametric battery model and a second measured set of inputs of the battery, wherein the second measured set of inputs of the battery is based on battery operation comprising aging.

In this manner it is advantageously possible to easily and reliably configure the system, while maintaining a low system complexity and a reduced amount of effort for testing.

A further embodiment can relate to a method for modelling at least one state of a battery, the method comprising measuring one or more characteristics of the battery as inputs, inputting the one or more inputs to a system according to any of the systems above or throughout the description, or a system trained according to the method for configuring the system as described above, or throughout the description, obtaining the modelled at least one state as an output from the system.

In this manner it is advantageously possible to provide an estimation of the state of the battery with a model having a reliable output while maintaining a low complexity.

A further embodiment can relate to a program code comprising instructions being configured to, when executed by a processor, cause the processor to implement any of the methods described above or throughout the description, or any of the systems described above or throughout the description.

In this manner it is advantageously possible to provide an estimation of the state of the battery by providing the input to the computer-implemented model. This advantageously allows a battery manager to collect data from various batteries located a different location and process them in a centralized manner.

### Brief description of the drawings

Figure 1 schematically illustrates a system 100 for modelling at least one state of a battery;
Figure 2 schematically illustrates a configuration environment 200 for configuring a parametric battery model 120;
Figure 3 schematically illustrates a training environment 300 for training a machine learning model 130;
Figure 4 schematically illustrates a method 400 for configuring a system 100 for modelling at least one state of a battery;
Figure 5 schematically illustrates a method 500 for modelling a battery;
Figure 6 schematically illustrates a computer-implemented model 600 for modelling a battery.

### Detailed description

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired.

It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

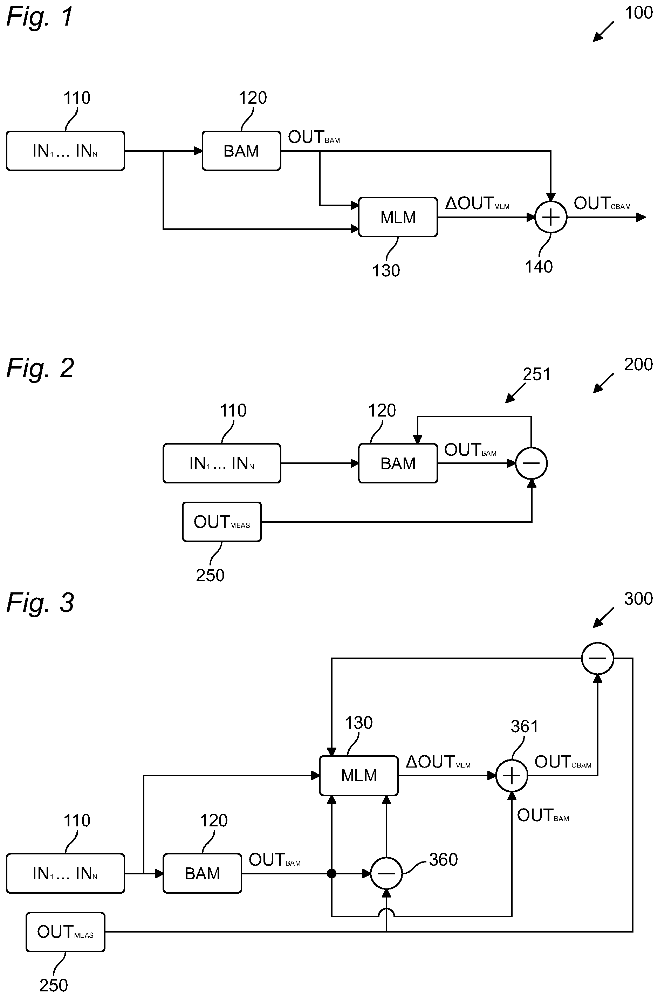

Figure 1 schematically illustrates a system 100 for modelling at least one state of a battery. Preferably, the modelling can be configured to model aging effects on the at least one state of the battery. The battery can be intended as a single battery cell, or a cell stack, or even as a plurality of batteries connected to each other. The at least one state which is modelled can be any of a plurality of states of the battery including, but not limited to, the state of health, state of charge, capacity, state of energy, etc.

Those states are notoriously difficult to be measured directly. For instance, in order to directly measure the capacity of the battery, it is often necessary to drain the battery and measure how much energy has been drained. Those direct measurements are thus often unacceptable, under normal operation of the battery.

Thus, parametric models have been developed which allow such states to be estimated, based on more simple measurements, such as voltage and current, which can be taken easily during normal operation of the battery.

Those parametric models can be thought of as models comprising a plurality of fixed and variable inputs. The fixed parameters, such as for instance the OCV curve, are generally more complex to be determined and thus are usually derived from laboratory measurements on the battery and then set to specific numeric values, associated to a specific battery, or battery type. The variable inputs are generally less complex to be determined, they could, for instance, be measured from the battery, such as voltage and current. At any given time, the combination of the values of the variable inputs with those of the fixed parameters results in the numerical estimation of the state for which the model is designed.

It will be understood that the system 100 can be implemented by physical elements corresponding to the various described elements thereof, for instance by appropriately designed circuits. Alternatively, or in addition, the system 100 can be implemented by one or more software elements. Still alternatively, or in addition, one or more elements of the system 100 can be implemented as circuits while one or more elements can be implemented as software.

The system 100 comprises one such parametric battery model 120, which is configured to receive one or more inputs IN₁ - IN_{N}, which can correspond to the variable inputs discussed above, and to provide an output OUT_{BAM} based thereon. That is, the one or more inputs IN₁ - IN_{N} can correspond to one or more characteristics of the battery which can be directly measured and/or computed from measurements on the battery.

The output OUT_{BAM} can thus provide an estimation of the state, which the parametric model is intended to model, for instance the state of health. In some embodiments, the parametric battery model 120 can be configured to model aging of the battery. The output OUT_{BAM} can thus be a function of the age of the battery as modelled by the parametric battery model 120.

It will be clear to those skilled in the art that there are several manners in which a parametric battery model 120 can be implemented to associate a given output value OUT_{BAM} to the one or more inputs IN₁ - IN_{N}. For instance, the parametric battery model 120 can be implemented by a look-up table. Alternatively, or in addition, the parametric battery model 120 can be implemented by a physical and/or chemical model of the battery, comprising physical and/or chemical equations modelling the operation of the battery. Still alternatively, or in addition, the parametric battery model 120 can be implemented by an empirical model, comprising empirically parameterized algebraic equations for capacity or power fade. Still alternatively, or in addition, the parametric battery model 120 can be implemented by a semi-empirical model, where "semi" refers to, for instance, a temperature dependence of aging, which can be modelled by the Arrhenius equation. Still alternatively, or in addition, the parametric battery model 120 can be implemented by a data-driven and/or blackbox model, where the aging is parameterized by any suitable mathematic method, such as machine learning methods.

In general, the parametric battery model 120 can thus be implemented by a model which corresponds to a function f, which, for any given combination of the one or more inputs IN₁ - IN_{N} provides a univocal value of OUT_{BAM} corresponding to f(IN₁ - IN_{N}). In some embodiments, the parametric battery model 120 can therefore be configured to quantify the influence of external conditions in dependence of charge-throughput during cycle aging and/or in dependence of time during calendar aging. In some further specific embodiments, the parametric battery model 120 can comprise algebraic expressions for capacity fade and/or power fade that is empirically parameterized on experimental aging tests.

In some preferred embodiment, the parametric battery model 120 does not include a modelling of battery aging. That is, in those embodiments, the parametric battery model 120 outputs a given value of OUT_{BAM} for a given combination of the one or more inputs IN₁ - IN_{N} independently on the age of the battery. Alternatively, or in addition, in some embodiments, the age of the battery is not an input to the parametric battery model 120. Still alternatively, or in addition, in some embodiments, effects on the given value of OUT_{BAM} for a given combination of the one or more inputs IN₁ - IN_{N} which are dependent on battery aging are not modelled. Still alternatively, or in addition, the parametric battery model 120 can be configured to only provide a first estimation of one or more aging effects, which can be further approximated by the machine learning model 130. Still alternatively, or in addition, the parametric battery model 120 can be configured to provide an estimation of a first one or more aging effects, while the machine learning model 130 can provide an estimation of a second one or more aging effects, different from the first one or more aging effects.

In particular, battery aging generally leads to capacity fade and power fade. The mechanisms behind battery aging, leading to capacity fade and power fade, are various. They comprise, for instance, any of SEI growth, SEI decomposition, electrolyte decomposition, structural disordering, lithium plating, loss of electric content, electrode particle cracking and/or dissolutions etc. The large number of different mechanisms leads to a capacity fade curve and power fade curve that is highly non-linear. This curve can generally only be approximated by an analytical equation, as implemented by the battery model 120. Attempts to more precisely estimate this curve generally result in an increase in number and complexity of the analytical equations of the parametric battery model 120.

As will become evident from the following, the machine learning model 130 allows using simpler analytical equations for the parametric battery model 120. For instance, the parametric battery model 120 can consider the effect of SEI growth, while the effects of the remaining mechanisms can be covered by the machine learning model 130. Alternatively, or in addition, the effect of SEI growth can be simulated in a simpler manner in the parametric battery model 120 while a more precise correction of this simpler model can be performed by the machine learning model 130. In some embodiments, the one or more inputs IN₁ - IN_{N} which are received by the parametric battery model 120 and/or by the machine learning model 130 can comprise one or more among:
- temperature,
- depth of discharge,
- state of charge,
- voltage,
- current,
of the battery. The specific inputs IN₁ - IN_{N} which are received by the parametric battery model 120 and by the machine learning model 130 do not need to be the same, however, in some embodiments, they can be.

It will be clear to those skilled in the art that the one or more inputs IN₁ - IN_{N} used for the parametric battery model 120 and/or for the machine learning model 130 depend on the battery aging effects which are to be modelled by the system 100,

The system 100 further comprises a machine learning model 130, which has been trained to correct an output OUT_{BAM} of the parametric battery model 120 based on battery operation comprising aging, such as data from real-world operation of the battery. In particular, the machine learning model 130 is configured to receive the one or more inputs IN₁ - IN_{N} and the output OUT_{BAM} and to provide an output ΔOUT_{MLM} based thereon.

Here, real-world battery operation can be understood as meaning that the battery which the system 100 is intended to model, and/or the battery which is modelled by the parametric battery model 120, or a battery sufficiently similar to any of those, can be employed in its field of use and data resulting therefrom are the basis for the training of the machine learning model 130. That is, real-world operation can be understood to correspond to collecting field-data during normal battery operation.

Preferably, the real-world battery operation is configured to result in data for training which show at least an effect of aging of the battery. That is, the real-world battery operation is configured to result in data which are affected by the aging of the battery. Thanks to this configuration, as will result clear from the following, the training of the machine learning model 130 can take into account aging of the battery and subsequently correct the output OUT_{BAM} of the parametric battery model 120.

Thanks to this configuration, battery aging effects such as those previously indicated, which are notoriously difficult to simulate and/or to be modelled by a parameter model, such as parametric battery model 120, can be modelled by the machine learning model 130, which has been trained for this purpose. This allows the system 100 to model the requested state of the battery through parametric battery model 120 and output a signal OUT_{BAM} with little, or even no, consideration about battery aging mechanisms, and/or considering only some battery aging mechanisms which can be easily implemented by the parametric battery model 120. The signal OUT_{BAM} can then subsequently be corrected for aging by the machine learning model 130, in a simple yet reliable manner.

In order to combine the output OUT_{BAM} and the output ΔOUT_{MLM}, and to provide an output OUT_{CBAM} based thereon, the system 100 comprises a combiner 140. In the illustrated embodiment, the combiner 140 can be implemented by an adder, adding ΔOUT_{MLM} to OUT_{CBAM}. However, the invention is not limited thereto and various other manners for modulating OUT_{BAM} with ΔOUT_{MLM}, for instance a multiplication, or any function f(ΔOUT_{BAM}, OUT_{MLM}.) can be implemented for obtaining OUT_{CBAM}.

It has thus been described how the system 100 can be implemented to model a battery. The system 100 is particularly advantageous as it allows any state of the battery to be modelled, depending on the appropriate configuration of the parametric battery model 120 and of the machine learning model 130. Moreover, the system 100 allows modelling of the aging of the battery as well as its impact on the state of the battery. The aging model can be shared between the parametric battery model 120 and the machine learning model 130, as previously described, with the machine learning model 130 correcting the output of the parametric battery model 120. This allows the parametric battery model 120 to be simplified with respect to a configuration in which a precise aging model needs to be implemented in the parametric battery model 120 alone. Alternatively, or in addition, the aging model can be carried out by the machine learning model 130, thus further simplifying the parametric battery model 120.

In preferred embodiments, the at least one state is a state of health of the battery. In this case, the output OUT_{BAM} can be a first estimation of the state of health of the battery, preferably with little or no considerations for battery aging mechanisms being embodied in the parametric battery model 120 outputting output OUT_{BAM}. The output ΔOUT_{MLM} can then be a correction of the output OUT_{BAM}, based on battery operation comprising aging, and preferably based on a training of the machine learning model 130 including battery aging mechanisms, so that those are reflected in the value of ΔOUT_{MLM}. The output OUT_{CBAM} can then be an improved estimation of the state of health of the battery, based on real-world battery operation, and preferably including the battery aging mechanisms, which can be difficult to model with the parametric battery model 120 and easily modelled by the machine learning model 130.

Figure 2 schematically illustrates a configuration environment 200 for configuring a parametric battery model 120.

In some embodiments, the parametric battery model 120 can be configured by a feedback loop 251 based on a difference between the output OUT_{BAM} and a measured value of the at least one state of a battery OUT_{MEAS}.

That is, as visible in figure 2, the at least one state of a battery which is intended to be modelled by the system 100, can be also measured, by known methods, resulting in a measured value OUT_{MEAS}. This measured value can be compared to, for instance subtracted from, the output OUT_{BAM} of the model 120. This allows a configuration, or a fine-tuning of the parametric model 120, in that the result of the comparison can be used as a feedback for configuring one or more of the parameters, preferably one or more of the previously described fixed parameters, of the parametric model 120.

Figure 3 schematically illustrates a training environment 300 for training the machine learning model 130.

In some embodiments, the machine learning model 130 can be trained by using as ground truth a measured value OUT_{MEAS} of the at least one state of a battery, as described above. In particular, in some embodiments, as illustrated in figure 3, the machine learning model 130 can also be provided as inputs with any of the one or more inputs IN₁ - IN_{N} and the output OUT_{BAM}. The machine learning model 130 can then be trained so as to output the value ΔOUT_{MLM} based on those inputs and the ground truth, such that the subsequent combination of ΔOUT_{MLM} and of OUT_{BAM} results in a value as close as possible to OUT_{MEAS}.

In the embodiment illustrated in figure 3, the machine learning model 130 is further provided with an input corresponding to the comparison of, preferably the difference between, OUT_{BAM} and OUT_{MEAS}, by means of combiner, preferably a subtraction element, 360. This allows advantageously providing the machine learning model 130 with a value indicative of the expected value for ΔOUT_{MLM}. Alternatively, or in addition, the illustrated machine learning model 130 can be further provided with an input corresponding to the comparison of, preferably the difference between, OUT_{CBAM} and OUT-_{MEAS} by means of combiner, preferably a subtraction element, 362. OUT_{CBAM} can correspond to the combination of, preferably the sum of, OUT_{BAM} and ΔOUT_{MLM}, by mean of combiner, preferably an adder, 361. This allows advantageously providing the machine learning model 130 with a feedback value indicative of the difference between the expected value of OUT_{MEAS} and the computed value OUT_{CBAM}. While those additional inputs, and the respective combiners which generate them, are illustrated as being implemented outside of the machine learning model 130, it will be clear that corresponding computations can also be implemented as part of the machine learning model 130 itself by providing the appropriate inputs.

In some preferred embodiments, the same inputs IN₁ - IN_{N} can be used for the training of the machine learning model 130 and for the configuration of the parametric battery model 120. Alternatively, or in addition, the inputs IN₁ - IN_{N} used for training the machine learning model 130 and for configuring the parametric battery model 120 can be different. In particular, while the types of inputs can be the same, their values can be different.

The values of the inputs IN₁ - IN_{N} used for configuring the parametric battery model 120 can be obtained from laboratory measurement, including or not aging effects. Alternatively, or in addition, the values can be obtained by models and/or simulations of the battery. Still alternatively, or in addition, the values can be obtained by battery data that is available before use of the battery, in situ. Still alternatively, or in addition, the values can be obtained by battery use with substantially constant conditions.

The values of the inputs IN₁ - IN_{N} used for training the machine learning model 130 can be obtained from real-world measurement, preferably including aging effects. Alternatively, or in addition, the values can be obtained by battery data that is available only after its deployment and/or use, in situ. Still alternatively, or in addition, the values can be obtained by battery use with substantially dynamic conditions. Still alternatively, or in addition, the values can be obtained by battery use in which subsequent half cycles are different from one another. In some embodiments this can be implemented by having different values for stress factors between subsequent half cycles, wherein the stress factors can comprise any of the mean state of charge, mean temperature, mean currents, mean depth of discharge.

Still alternatively, or in addition, the values of the inputs IN₁ - IN_{N} used for training the machine learning model 130 can be obtained from real-world measurement in which aging effect are above a predetermined threshold. In particular, the threshold can be a minimum variation in the state of a battery modelled by the system 100, for instance the state of health. That is, the values of the inputs IN₁ - IN_{N} can be derived from operation of the battery which results in at least a minimum variation of the modelled state. In some embodiments, this variation can be at least 0.1%, preferably at least 1%, and/or at most 20%, preferably at most 10%. In some embodiments, the variation can be selected to be higher, preferably significantly higher, than the accuracy of the source of ground-truth state-estimation. This advantageously ensures that the values of the inputs IN₁ - IN_{N} can include aging effects which are significant for correctly training the machine learning model 130.

In some embodiments, particularly in those where the parametric battery model 120 is configured to also model aging effects, similar considerations can apply to the values of the inputs IN₁ - IN_{N} used for the configuration of the parametric battery model 120.

In some preferred embodiments, a first amount of aging, for instance a change in the state of the battery, can be experienced by the battery in the operation resulting in the values of the inputs IN₁ - IN_{N} used for the training of the machine learning model 130. Similarly, a second amount of aging can be experienced by the battery in the operation resulting in the values of the inputs IN₁ - IN_{N} used for the configuration of the parametric battery model 120. Preferably, the second amount of aging is lower than the first amount of aging.

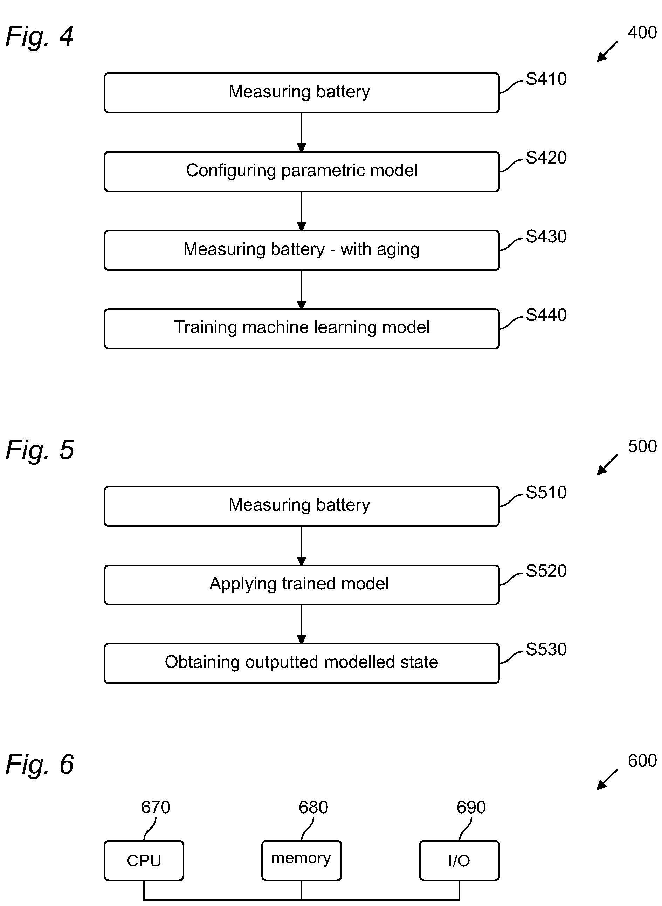

Figure 4 schematically illustrates a method 400 for configuring a system 100 for modelling at least one state of a battery.

In particular, the method 400 allows configuration of the system 100 which can comprise any of the elements as previously described. In a step S410, the status of the battery is measured.

This can comprise measuring a plurality of values for the inputs IN₁ - IN_{N} which can thereafter be used for the configuration of the parametric battery model 120 and/or for the training of the machine learning model 130. The considerations previously made with respect to the characteristics of the inputs IN₁ - IN_{N} and on the values for the inputs IN₁ - IN_{N} also apply to this step.

In a step S420, the parametric battery model 120 can be configured based on at least a first measured set of inputs of the battery, as measured in step S410.

Furthermore, in a step S440 the machine learning model 130 is trained based on at least the output of the configured parametric battery model 120 and a second measured set of inputs of the battery, wherein the second measured set of inputs of the battery is based on battery operation comprising aging.

In particular, in case the data collected during the step S410, namely the first measured set of inputs, comprises sufficient aging effects for the step S440, then the first measured set of inputs can be used for both steps S420 and S440. In this case, the second measured set of inputs can correspond to the first measured set of inputs.

On the other hand, in case the data collected during the step S410 does not comprise sufficient aging effects for the training step S440, then the method can further comprise an additional measuring strep S430, resulting in a second measured set of inputs. The measuring step S430 can result in the acquisition of data comprising aging effects, and/or in the acquisition of data comprising more aging effects than step S410. The considerations previously made to how the aging effects can be defined and/or quantified also apply to steps S410 and S430.

Figure 5 schematically illustrates a method 500 for modelling at least one state of a battery. The method 500 comprises a step S510 of measuring one or more characteristics of the battery as inputs IN₁ - IN_{N} for the model. In a subsequent step S520, the one or more inputs IN₁ - IN_{N} can be inputted to a system 100 as previously described, or a system configured and/or trained as previously described. Afterwards, the modelled at least one state can be obtained as outputted from the model.

Figure 6 schematically illustrates a computer-implemented model 600 for modelling at least one state of a battery. The computer-implemented model 600 can generally be configured for modelling at least one state of a battery, so that previous considerations made for the systems and methods described can be applied to the model 600. In particular, the computer-implemented model 600 can comprising a processor 670, which can be implemented by any processing unit, such as for instance as CPU, and a memory 680. The memory can comprise instructions being configured to, when executed by the processor 670, cause the processor 670 to implement any of the previously described method steps, or any of the characteristics of the previously described system 100.

In some embodiments, the model 600 can further comprise input/output means 690 for inputting and outputting data, for instance for retrieving data measured from the battery and outputting values for the at least one state of the battery modelled by the computer-implemented model 600.

It has thus been described how a combination of a parametric model with a machine learning model can provide a simpler and yet more reliable modelling for aging effects in a battery, as compared to a more complex parametric model alone. While maintaining the parametric model as basis, the invention advantageously allows aging effects to be modelled in the machine learning model, and/or to use the machine learning model to apply a correction to again effect modelled in the parametric model. Due to the nature of aging effects, it has been found that this hybrid implementation provides a simpler model, particular for what concerns the configuration and training of the model itself, than a parametric model alone, while nevertheless providing a more reliable output across a wider variation of battery states and aging effects and magnitudes.

### List of reference numerals

100: parametric battery aging model
120: parametric battery model
130: machine learning model
140: combiner
IN₁ - IN_{N}: input
OUT_{BAM}: first output
ΔOUT_{MLM}: second output
OUT_{CBAM}: third output
200: configuration of parametric battery aging model
250: measured state
251: feedback loop
300: training of machine learning model
360, 361: combiner
400: method
S410: measuring battery
S420: configuring parametric battery model
S430: measuring battery including aging
S430: training machine learning model 500: method
S510: measuring battery
S520: inputting value to model
S530: obtaining modelled state
600: computer-implemented model
670: CPU
680: memory
690: Input/Output

## Claims

1. System (100) for modelling at least one state of a battery, the system comprising a parametric battery model (120), configured to receive one or more inputs (IN₁ - IN_{N}) and to provide a first output (OUT_{BAM}) based thereon,
a machine learning model (130), which has been trained to correct an output (OUT_{BAM}) of the parametric battery model (120), configured to receive one or more inputs (IN₁ - IN_{N}) and the first output (OUT_{BAM}) and to provide a second output (ΔOUT_{MLM}) based thereon, **characterised in that**
the machine learning model (130) has been trained based on at least the first output (OUT_{BAM}) of the configured parametric battery model (120) and a measured set of inputs of the battery, wherein the measured set of inputs of the battery is based on battery operation comprising aging, the system further comprising a combiner (140), configured to receive the first output (OUT_{BAM}) and the second output (ΔOUT_{MLM}) and to provide a third output (OUT_{CBAM}) based thereon.

2. The system (100) according to claim 1
wherein the one or more inputs (IN₁ - IN_{N}) comprise one or more among:
- temperature,
- depth of discharge,
- state of charge,
- voltage,
- current,
of the battery.

3. The system (100) according to any previous claim wherein,
the at least one state is a state of health of the battery,
the first output (OUT_{BAM}) is a first estimation of the state of health of the battery,
the second output (ΔOUT_{MLM}) is a correction of the first output (OUT_{BAM}), based on battery operation comprising aging,
the third output (OUT_{CBAM}) is an improved estimation of the state of health of the battery, based on real-world battery operation.

4. The system (100) according to any previous claim wherein the parametric battery model (120) has been configured by a feedback loop (251) based on a difference between the first output (OUT_{BAM}) and a measured value of the at least one state of a battery (OUT_{MEAS}).

5. The system (100) according to any previous claim wherein, the machine learning model (130) is trained by using as ground truth a measured value of the at least one state of a battery (OUT_{MEAS}).

6. A method (400) for configuring a system (100) for modelling at least one state of a battery, the system (100) comprising a parametric battery model (120) and a machine learning model (130), the method comprising the steps of:
configuring (S420) the parametric battery model (120) based on at least a first measured set of inputs of the battery,
**characterised by** training (S440) the machine learning model (130) based on at least an output of the configured parametric battery model (120) and a second measured set of inputs of the battery, wherein the second measured set of inputs of the battery is based on battery operation comprising aging.

7. A method (500) for modelling at least one state of a battery, the method (500) comprising:
measuring (S510) one or more characteristics of the battery as inputs (IN₁ - IN_{N}), inputting (S520) the one or more inputs (IN₁ - IN_{N}) to a system (100) according to any of claims 1-5, or a system configured according to the method of claim 6,
obtaining (S530) the modelled at least one state as an output from the system (100).

8. A program code comprising instructions which, when the program code is executed by a processor (670), cause the processor (670) to implement the method of claims 6 or 7.

## Patentansprüche

1. System (100) zum Modellieren mindestens eines Zustands einer Batterie, wobei das System ein parametrisches Batteriemodell (120) umfasst, das so konfiguriert ist, dass es eine oder mehrere Eingaben (IN₁ - IN_{N}) empfängt und eine erste Ausgabe (OUT_{BAM}) darauf basierend bereitstellt,
ein maschinelles Lernmodell (130), das trainiert wurde, um eine Ausgabe (OUT_{BAM}) des parametrischen Batteriemodells (120) zu korrigieren, das so konfiguriert ist, dass es eine oder mehrere Eingaben (IN₁ - IN_{N}) und die erste Ausgabe (OUT_{BAM}) empfängt und eine zweite Ausgabe (ΔOUT_{MLM}) darauf basierend bereitstellt, **dadurch gekennzeichnet, dass**
das maschinelle Lernmodell (130) basierend auf mindestens der ersten Ausgabe (OUT_{BAM}) des konfigurierten parametrischen Batteriemodells (120) und eines gemessenen Satzes von Eingaben der Batterie trainiert wurde, wobei der gemessene Satz von Eingaben der Batterie auf dem Batteriebetrieb, der die Alterung umfasst, basiert, wobei das System ferner einen Kombinierer (140) umfasst, der so konfiguriert ist, dass er die erste Ausgabe (OUT_{BAM}) und die zweite Ausgabe (ΔOUT_{MLM}) empfängt und darauf basierend eine dritte Ausgabe (OUT_{CBAM}) bereitstellt.

2. System (100) nach Anspruch 1
wobei die eine oder die mehreren Eingaben (IN₁ - IN_{N}) eines oder mehrere der folgenden umfassen:
- Temperatur,
- Tiefe der Entladung,
- Zustand der Ladung,
- Spannung,
- Strom, der Batterie.

3. System (100) nach einem der vorstehenden Ansprüche, wobei
der mindestens eine Zustand ein Gesundheitszustand der Batterie ist,
die erste Ausgabe (OUT_{BAM}) eine erste Schätzung des Gesundheitszustands der Batterie ist,
die zweite Ausgabe (ΔOUT_{MLM}) eine Korrektur der ersten Ausgabe (OUT_{BAM}) ist, die auf dem Batteriebetrieb mit Alterung basiert,
die dritte Ausgabe (OUT_{CBAM}) eine verbesserte Schätzung des Gesundheitszustands der Batterie ist, die auf dem realen Batteriebetrieb basiert.

4. System (100) nach einem der vorstehenden Ansprüche, wobei das parametrische Batteriemodell (120) durch eine Rückkopplungsschleife (251) basierend auf einer Differenz zwischen dem ersten Ausgabesignal (OUT_{BAM}) und einem gemessenen Wert des mindestens einen Zustands einer Batterie (OUT_{MEAS}) konfiguriert wurde.

5. System (100) nach einem der vorstehenden Ansprüche, wobei das maschinelle Lernmodell (130) trainiert wird, indem als Grundwahrheit ein gemessener Wert des mindestens einen Zustands einer Batterie (OUT_{MEAS}) verwendet wird.

6. Verfahren (400) zum Konfigurieren eines Systems (100) zum Modellieren mindestens eines Zustands einer Batterie, wobei das System (100) ein parametrisches Batteriemodell (120) und ein maschinelles Lernmodell (130) umfasst, wobei das Verfahren die folgenden Schritte umfasst:
Konfigurieren (S420) des parametrischen Batteriemodells (120) basierend auf mindestens einem ersten gemessenen Satz von Eingaben der Batterie,
**gekennzeichnet durch** das Trainieren (S440) des maschinellen Lernmodells (130) basierend auf mindestens einer Ausgabe des konfigurierten parametrischen Batteriemodells (120) und eines zweiten gemessenen Satzes von Eingaben der Batterie, wobei der zweite gemessene Satz von Eingaben der Batterie auf dem Batteriebetrieb mit Alterung basiert.

7. Verfahren (500) zum Modellieren mindestens eines Zustands einer Batterie, wobei das Verfahren (500) umfasst:
Messen (S510) eines oder mehrerer Merkmale der Batterie als Eingaben (IN₁ - IN_{N}), Eingeben (S520) der einen oder der mehreren Eingaben (IN₁ - IN_{N}) in ein System (100) nach einem der Ansprüche 1 bis 5 oder ein System, das nach dem Verfahren von Anspruch 6 konfiguriert ist,
Erhalten (S530) des mindestens einen modellierten Zustands als eine Ausgabe des Systems (100).

8. Programmcode mit Anweisungen, die, wenn der Programmcode von einem Prozessor (670) ausgeführt wird, den Prozessor (670) veranlassen, das Verfahren nach Anspruch 6 oder 7 durchzuführen.

## Revendications

1. Système (100) de modélisation d'au moins un état d'une batterie, le système comprenant un modèle de batterie paramétrique (120), configuré pour recevoir une ou plusieurs entrées (IN₁ - IN_{N}) et pour fournir une première sortie (OUT_{BAM}) sur la base de ces dernières,
un modèle d'apprentissage automatique (130), qui a été entraîné pour corriger une sortie (OUT_{BAM}) du modèle de batterie paramétrique (120), configuré pour recevoir une ou plusieurs entrées (_{IN1} - _{INN}) et la première sortie (OUT_{BAM}) et pour fournir une deuxième sortie (ΔOUT_{MLM}) sur la base de ces dernières, **caractérisé en ce que** le modèle d'apprentissage automatique (130) a été entraîné sur la base d'au moins la première sortie (OUT_{BAM}) du modèle de batterie paramétrique configuré (120) et d'un ensemble mesuré d'entrées de la batterie, l'ensemble mesuré d'entrées de la batterie étant basé sur un fonctionnement de batterie comprenant le vieillissement, le système comprenant en outre un combinateur (140), configuré pour recevoir la première sortie (OUT_{BAM}) et la deuxième sortie (ΔOUT_{MLM}) et pour fournir une troisième sortie OUT_{CBAM}) sur la base de ces dernières.

2. Système (100) selon la revendication 1
dans lequel la ou les entrées (IN₁ - IN_{N}) comprennent une ou plusieurs entrées parmi :
- la température,
- la profondeur de décharge,
- l'état de charge,
- la tension,
- le courant, de la batterie.

3. Système (100) selon l'une quelconque des revendications précédentes dans lequel,
l'au moins un état est un état de santé de la batterie,
la première sortie (OUT_{BAM}) est une première estimation de l'état de santé de la batterie,
la deuxième sortie (ΔOUT_{MLM}) est une correction de la première sortie (OUT_{BAM}), basée sur le fonctionnement de batterie comprenant le vieillissement,
la troisième sortie (OUT_{BAM}) est une estimation améliorée de l'état de santé de la batterie, basée sur le fonctionnement réel de batterie.

4. Système (100) selon l'une quelconque des revendications précédentes dans lequel le modèle paramétrique de batterie (120) a été configuré par une boucle de rétroaction (251) basée sur une différence entre la première sortie (OUT_{BAM}) et une valeur mesurée de l'au moins un état d'une batterie (OUT_{MEAS}).

5. Système (100) selon l'une quelconque des revendications précédentes dans lequel le modèle d'apprentissage automatique (130) est formé en utilisant comme vérité de base une valeur mesurée de l'au moins un état d'une batterie (OUT_{MEAS}).

6. Procédé (400) de configuration d'un système (100) de modélisation d'au moins un état d'une batterie, le système (100) comprenant un modèle de batterie paramétrique (120) et un modèle d'apprentissage automatique (130), le procédé comprenant les étapes suivantes :
configurer (S420) le modèle paramétrique de batterie (120) sur la base d'au moins un premier ensemble mesuré d'entrées de la batterie,
**caractérisé par** l'entraînement (S440) du modèle d'apprentissage automatique (130) sur la base d'au moins une sortie du modèle de batterie paramétrique configuré (120) et d'un second ensemble mesuré d'entrées de la batterie, dans lequel le second ensemble mesuré d'entrées de la batterie est basé sur le fonctionnement de batterie comprenant le vieillissement.

7. Procédé (500) de modélisation d'au moins un état d'une batterie, le procédé (500) comprenant :
la mesure (S510) d'une ou de plusieurs caractéristiques de la batterie en tant qu'entrées (IN₁ - IN_{N}),
l'introduction (S520) des une ou plusieurs entrées (_{IN1} - _{INN}) dans un système (100) selon l'une quelconque des revendications 1 à 5, ou un système configuré selon le procédé selon la revendication 6,
l'obtention (S530) de l'au moins un état modélisé en tant que sortie du système (100).

8. Code de programme comprenant des instructions qui, lorsque le code de programme est exécuté par un processeur (670), amènent le processeur (670) à mettre en œuvre le procédé selon les revendications 6 ou 7.
